# FASCICULE DE BREVET EUROPEEN

(11) **EP 3 866 270 B1**
(45) Date de publication et mention de la délivrance du brevet: **20.09.2023**
(21) Numéro de dépôt: 21156861.3
(22) Date de dépôt: 12.02.2021
(51) Int. Cl.: H01R 11/30, H01R 43/24, H01R 101/00

(54) **CONNECTEUR MAGNÉTIQUE ET GROUPE DE CONNECTEURS MAGNÉTIQUES**
MAGNETANSCHLUSS UND GRUPPE VON MAGNETANSCHLÜSSEN
MAGNETIC CONNECTOR AND GROUP OF MAGNETIC CONNECTORS

(30) Priorité: 13.02.2020 FR 2001422
(43) Date de publication de la demande: 18.08.2021
(73) Titulaire: Schneider Electric Industries SAS, 92500 Rueil-Malmaison (FR)
(72) Inventeur: PUPIN, Thomas, 38000 Grenoble (FR); TIAN, Simon, 38000 Grenoble (FR)
(74) Mandataire: Lavoix

(56) Documents cités:
- WO-A1-2017/211041
- JP-A- 2007 073 477
- JP-U- H0 734 562
- KR-A- 20140 013 773
- US-A1- 2016 344 117

## Description

La présente invention concerne un connecteur magnétique pour la connexion d'un appareil électrique sur un tableau électrique. L'invention concerne également un groupe de connecteurs comprenant de tels connecteurs magnétiques.

US-A-2016 344117 décrit un connecteur magnétique comprenant un aimant, une structure métallique et une gaine thermorétractable recouvrant l'aimant et la structure métallique.

Pour divers usages, notamment la mesure de consommation d'énergie, la mesure de température, les test diélectriques ou l'alimentation électrique de divers appareils électriques, il est parfois nécessaire de connecter un câble sur une source de tension d'un tableau électrique, par exemple une vis de disjoncteur. Habituellement, il est nécessaire de dévisser une vis et de la revisser après avoir mis en place un câble électrique pour obtenir le courant. Cette opération est peu pratique et peu fiable, d'autant plus que l'espace disponible entre les vis des disjoncteurs et le capot avant d'un tableau électrique est réduit.

C'est à ces inconvénients qu'entend remédier l'invention en proposant un connecteur magnétique permettant de connecter un appareil électrique sur un tableau électrique de manière plus aisée et plus fiable.

A cet effet, l'invention concerne un connecteur magnétique tel que défini à la revendication 1.

Grâce à l'invention, le connecteur magnétique assure à la fois le maintien mécanique et la connexion électrique, facilitant la connexion d'appareils électriques.

Des aspects avantageux mais non obligatoires de l'invention sont spécifiés aux revendications 2 à 8.

L'invention concerne également un groupe de connecteurs magnétiques tel que défini à la revendication 9.

L'invention sera mieux comprise et d'autres avantages de celle-ci apparaitront plus clairement à la lumière de la description qui va suivre d'un connecteur magnétique conforme à son principe, faite à titre d'exemple non limitatif en référence aux dessins annexés dans lesquels :
[Fig 1] La Figure 1 est une vue en perspective d'un tableau électrique ouvert ;
[Fig 2] La Figure 2 est une coupe transversale du tableau électrique de la figure 1 sur lequel est connecté un connecteur magnétique conforme à l'invention ;
[Fig 3] La Figure 3 est une vue en perspective éclatée d'un connecteur magnétique conforme à un premier mode de réalisation de l'invention ;
[Fig 4] La Figure 4 est une vue de côté du connecteur magnétique de la figure 3, connecté sur une vis d'un tableau électrique ;
[Fig 5] La Figure 5 est une vue de dessous du connecteur magnétique de la figure 3 ;
[Fig 6] La Figure 6 est une vue en perspective d'une première étape d'assemblage du connecteur magnétique de la figure 3 ;
[Fig 7] La Figure 7 représente une vue en perspective d'une deuxième étape d'assemblage du connecteur magnétique de la figure 3 ;
[Fig 8] La Figure 8 représente une vue en perspective d'un troisième étape d'assemblage du connecteur magnétique de la figure 3 ;
[Fig 9] La Figure 9 est une vue de dessous d'un connecteur magnétique conforme à un second mode de réalisation de l'invention ;
[Fig 10] La Figure 10 est une vue en perspective éclatée du connecteur magnétique de la figure 9 ;
[Fig 11] La Figure 11 est une vue en perspective d'un ensemble de trois groupes de connecteurs liés les uns aux autres par des pièces de liaison.

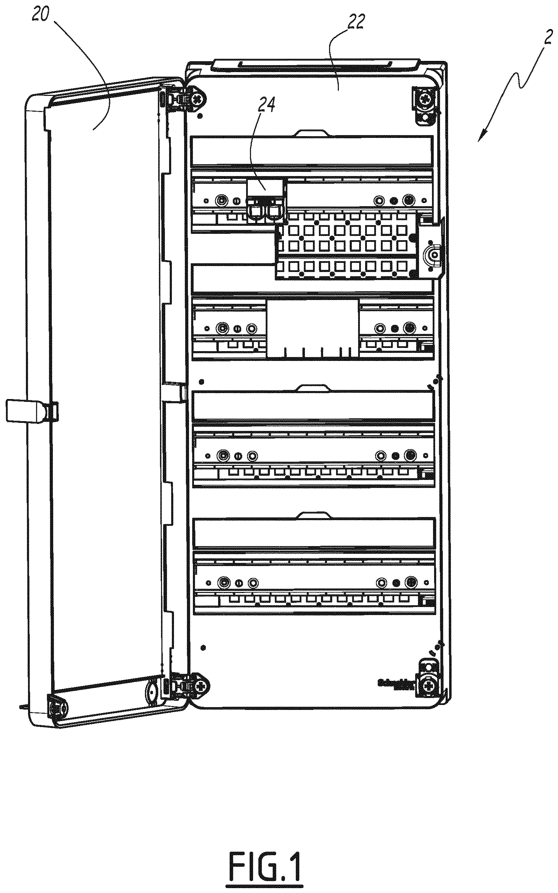

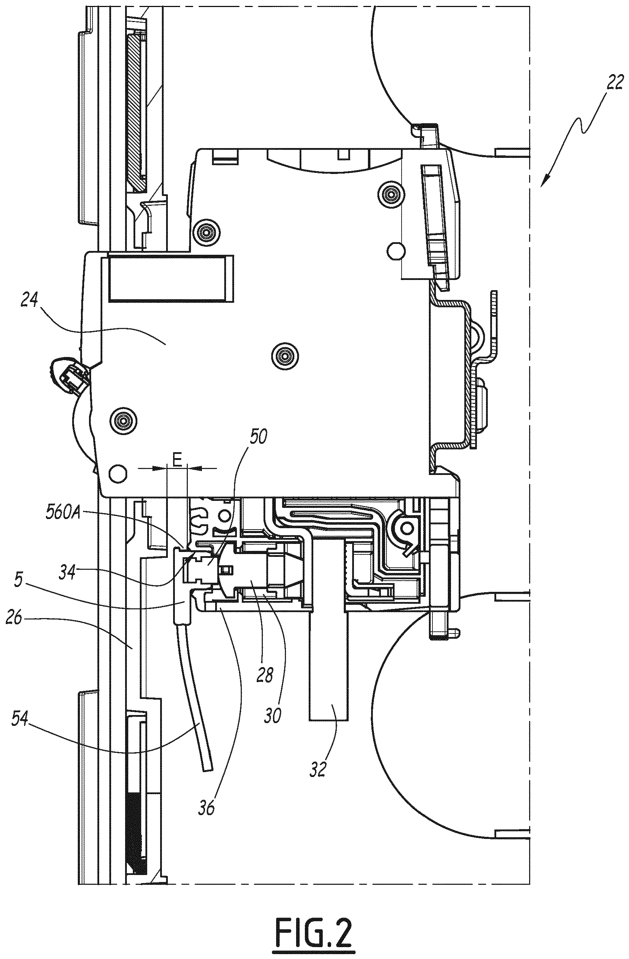

Les figures 1 et 2 représentent un placard électrique 2, comportant un capot de fermeture 20 et un tableau électrique 22. Le tableau électrique 22 comprend un disjoncteur 24 et un plastron 26 formant une face avant du tableau électrique 22. Le disjoncteur 24 est relié à plusieurs vis, dont au moins une est représentée à la figure 2 avec la référence 28, qui sont vissées sur des bornes électriques 30, ou cages, vues en coupe à la figure 2, et qui fixent et connectent électriquement des câbles 32 par lesquels le disjoncteur 24 est alimenté en courant électrique. La vis 28 est insérée dans un logement 34 d'une embase 36 du disjoncteur 24. L'embase 36 est séparée d'une face interne du plastron 26 par un espace E.

La figure 2 représente un connecteur magnétique 5 pour la connexion d'un appareil électrique (non représenté), ce connecteur magnétique 5 étant connecté sur le tableau électrique 22, et plus précisément sur la vis 28.

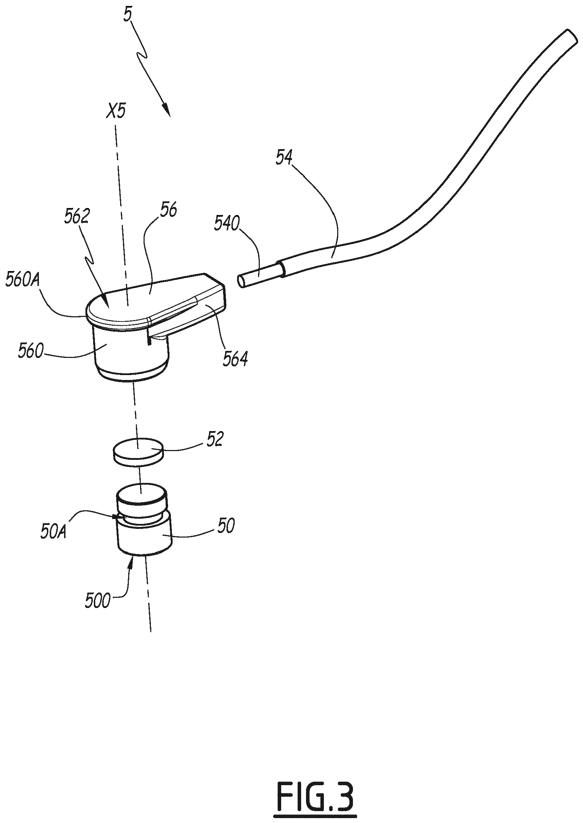

Comme cela est visible à la figure 3, le connecteur 5 comprend au moins un aimant 50, une pièce métallique conductrice 52 solidaire de cet aimant 50, un câble de connexion 54 fixé sur la pièce métallique conductrice 52, et une capsule en matière plastique 56, surmoulée sur le câble de connexion 54, la pièce métallique conductrice 52 et l'aimant 50, excepté une surface de contact 500 de l'aimant 50, destinée à être mise en contact avec la vis 28 du tableau électrique 22.

L'aimant 50 adhère à la vis 28 du fait de l'attraction magnétique entre la vis 28 et la surface de contact 500, qui est plane. L'aimant 50 assure donc l'ancrage mécanique du connecteur 5 sur la vis 28.

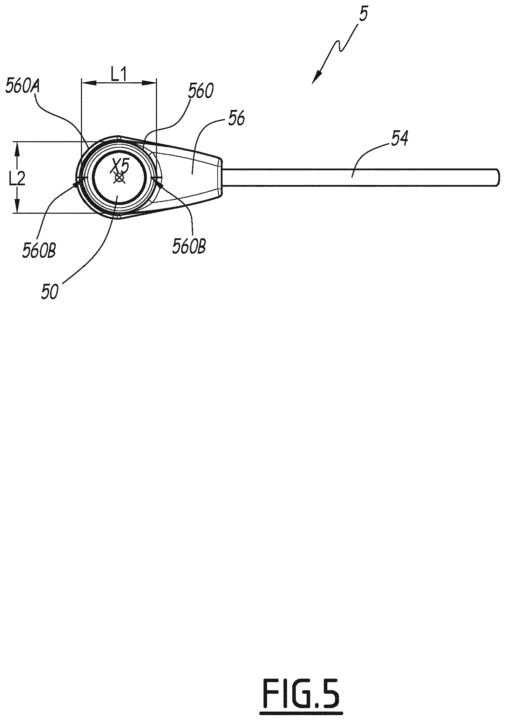

Selon un premier mode de réalisation représenté sur les figures 3 à 8, le connecteur magnétique 5 comporte un unique aimant 50 de forme cylindrique centrée autour d'un axe central X5. La surface de contact 500 est de forme circulaire et perpendiculaire à l'axe central X5.

L'aimant 50 présente une rainure circonférentielle 50A dans laquelle la matière de la capsule en matière plastique 56 est engagée. Cette rainure 50A permet de renforcer l'ancrage mécanique de l'aimant 50 dans la capsule plastique 56.

La pièce métallique conductrice 52 a la forme d'une rondelle centrée sur l'axe central X5. Cette pièce 52 est fixée à l'aimant 50 par attraction magnétique. La pièce métallique conductrice 52 est de préférence fabriquée en un matériau métallique paramagnétique.

Le câble de connexion 54 a une extrémité dénudée 540 qui est soudée sur la pièce métallique conductrice 52. Ainsi il existe une continuité électrique entre l'aimant 50, la pièce métallique conductrice 52 et le câble 54.

Le câble 54 est relié à un appareillage électrique non représenté, par exemple un détecteur de tension, de température, etc.

La capsule en matière plastique 56 présente une partie longitudinale 560 s'étendant selon l'axe central X5 et terminée par une surface plane 562 parallèle à la surface de contact 500 de l'aimant 50. L'aimant 50 et la pièce conductrice métallique 52 sont logés dans cette partie longitudinale 560. Le câble de connexion 54 est orienté transversalement par rapport à la partie longitudinale 560 et encapsulé dans une partie radiale 564 de la capsule 56, qui prolonge la surface plane 562.

La partie longitudinale 560 comprend au moins une nervure périphérique de préhension 560A prévue dans le prolongement de la partie radiale 564. Cette nervure 560A forme une saillie de la partie longitudinale 560 et permet à un utilisateur de manipuler le connecteur 5 notamment en passant son doigt ou son ongle sous la nervure 560A pour saisir le connecteur 5, ou pour le désolidariser de la vis 28. En variante non représentée, le connecteur 5 peut avoir plus d'une nervure 560A par exemple deux nervures parallèles.

La partie longitudinale 560 est de forme cylindrique centrée sur l'axe central X5 et présente au moins un renflement longitudinal 560B de manière à produire un frottement dans le logement 34.

Dans cet exemple, la partie longitudinale 560 présente deux renflements longitudinaux 560B diamétralement opposés par rapport à l'axe central X5, formés par le fait que la partie longitudinale 560 a un profil transversal elliptique, dont la plus grande dimension L1 a une longueur, par rapport à la plus petite dimension L2, supérieure de 0.2 à 0.4 mm. La plus grande dimension L1 forme ici le plus grand diamètre de l'ellipse formée par la base du cylindre formant la partie longitudinale 560, tandis que la plus petite dimension L2 correspond au plus petit diamètre. Ces renflements longitudinaux 560B permettent de renforcer l'ancrage mécanique du connecteur 5 dans son logement 34 par un frottement, qui s'ajoute à l'attraction magnétique de l'aimant 50. Selon une variante non représentée, les renflements longitudinaux pourraient également être formés par des protubérances telles que des nervures.

La dimension longitudinale L5 du connecteur 5, prise selon l'axe central X5 entre la surface de contact 500 et la surface plane 562, est de préférence comprise entre 7 et 12 mm. Ce faible encombrement permet au connecteur magnétique 5 d'être logé facilement dans un tableau électrique sous le plastron 26 dans l'espace E. Egalement, la partie du connecteur 5 dépassant du logement 34, c'est-à-dire la partie radiale 564 et son prolongement sur la partie longitudinale 560 entourée par la nervure 560A, et l'orientation radiale du câble 54, font que le connecteur 5 a une faible hauteur en saillie, ce qui permet son logement dans l'espace E.

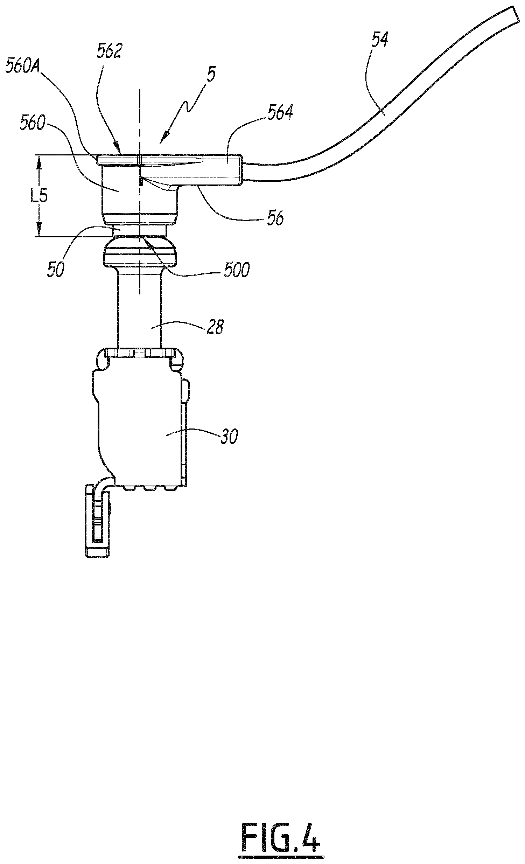

La figure 4 montre le montage du connecteur 5 sur la vis 28. La borne 30 est vue non sectionnée et sans câble 32. Une partie de l'aimant 50 qui porte la surface de contact 500 fait saillie de la capsule surmoulée 56 selon l'axe central X5. L'aimant 50 et la vis 28 sont soumis à une force d'attraction magnétique augmentée de la force de frottement exercée par les renflements 560B dans le logement 34, pour donner une force de maintien mécanique équivalente à une masse comprise entre 500g et 1 kg.

Le courant électrique est conduit entre la borne 30 et la vis 28. La résistance électrique de l'ensemble borne 30 + vis 28 est comprise de préférence entre 0,1 et 0,3 Ω. Le courant électrique est conduit entre la tête de la vis 28 et l'aimant 50, avec une résistance de contact comprise de préférence entre 0,1 et 0,3 Ω.

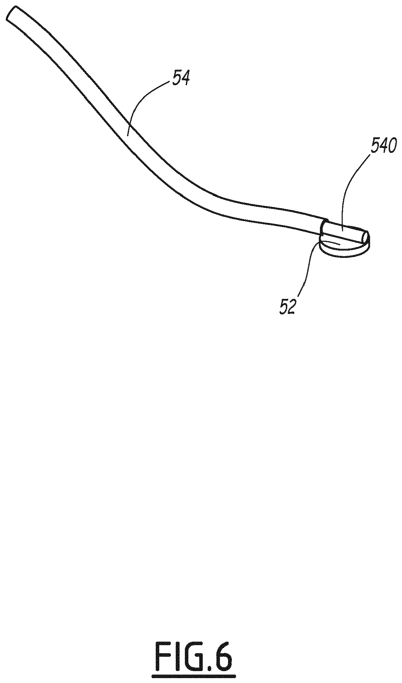

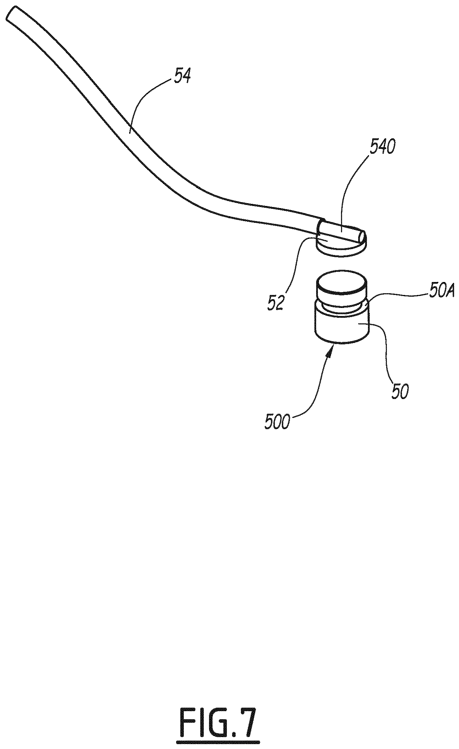

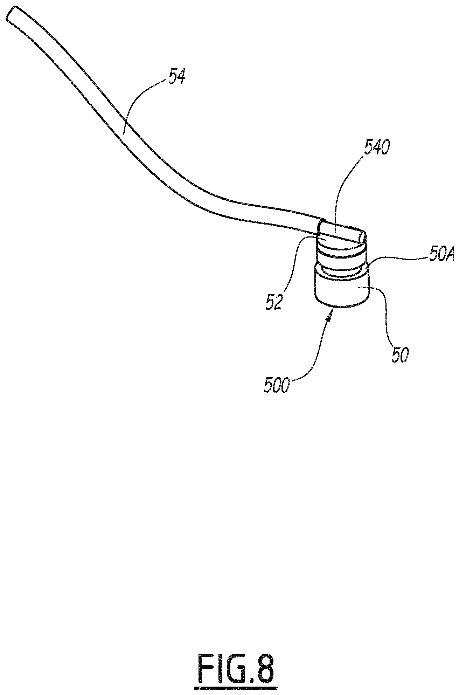

Les figures 6 à 8 représentent un procédé de fabrication du connecteur magnétique 5. A la figure 6, Le câble de connexion 54 avec sa partie dénudée 540 est soudé à la pièce conductrice métallique 52. A la figure 7, l'aimant 50 est fixé à la pièce conductrice métallique 52 par attraction magnétique. A la figure 8, l'ensemble formé par la partie dénudée 540, la pièce conductrice métallique 52 et l'aimant 50 est placé dans un moule d'injection non représenté, par exemple un moule basse pression, dans lequel est injecté de la matière plastique pour surmouler la capsule plastique 56, et obtenir le connecteur 5 final tel qu'il apparaît à la figure 4.

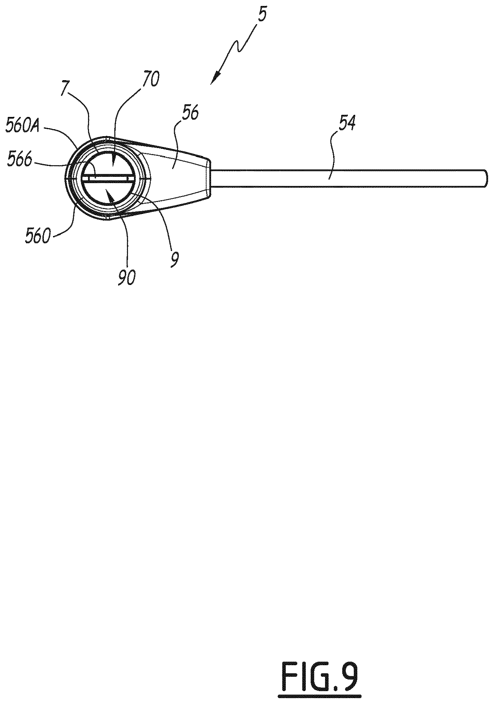

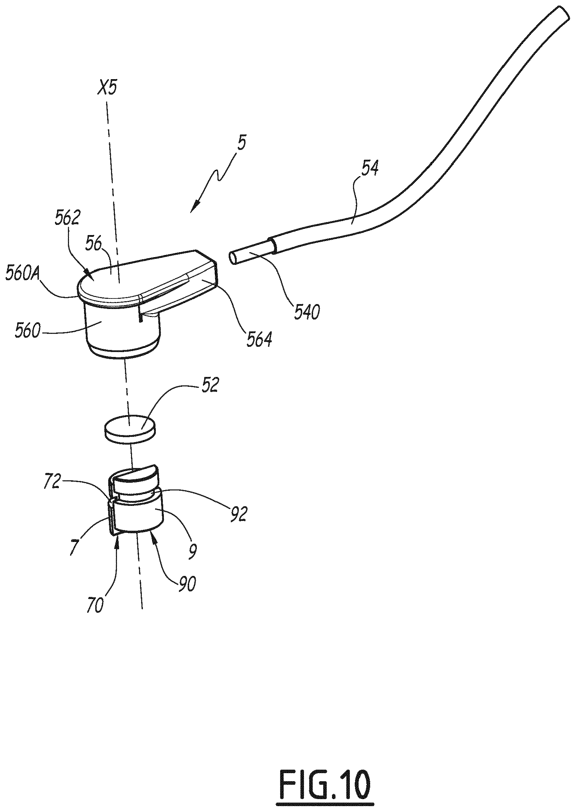

Un deuxième mode de réalisation de l'invention est représenté sur les figures 9 et 10. Dans ce mode de réalisation, les éléments communs au premier mode portent les mêmes références et fonctionnent de la même manière.

Dans ce mode de réalisation, le connecteur 5 comporte deux aimants 7 et 9 de polarités inversées. Les deux aimants 7 et 9 sont de préférence de forme demi-cylindrique séparés l'un de l'autre par une paroi 566 venue de matière avec la capsule plastique 56. Cette paroi 566 permet d'assurer l'isolation magnétique et physique des deux aimants 7 et 9. La paroi 566 est alignée avec l'axe central X5.

Chacun des aimants 7 et 9 présente une surface de contact demi-circulaire respective 70 et 90, ainsi qu'une rainure périphérique respective 72 et 92.

Selon une variante non représentée, la pièce métallique conductrice 52 peut présenter deux logements de positionnement des aimants 7 et 9 afin d'assurer qu'ils ne sont pas attirés par force magnétique préalablement à leur surmoulage dans la capsule plastique 56.

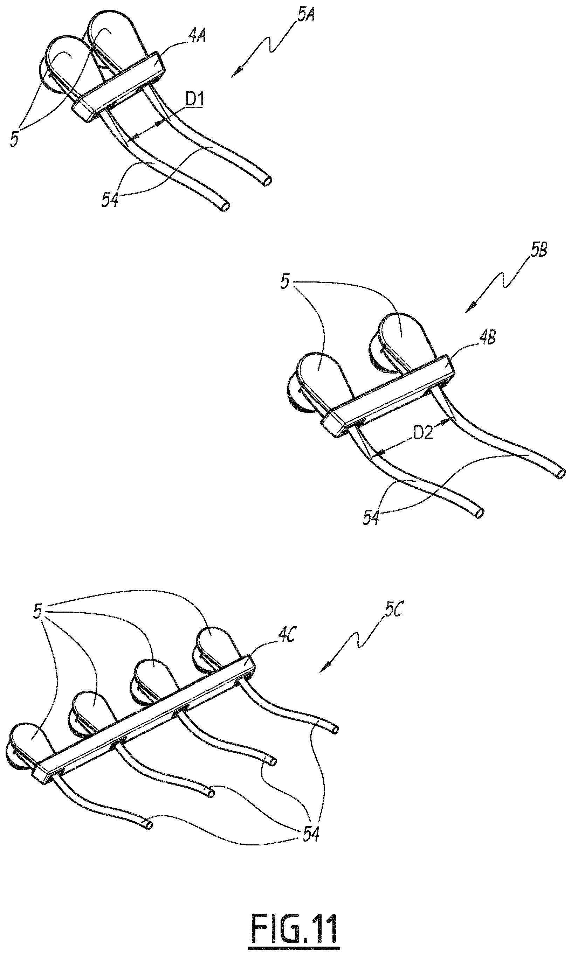

Un troisième mode de réalisation de l'invention est représenté sur la figure 11. Dans ce mode de réalisation, plusieurs connecteurs magnétiques 5 peuvent être reliés en parallèle à plusieurs pièces conductrices 28 du tableau électrique 22. Ces connecteurs magnétiques 5 sont groupés sous forme de groupes de connecteurs magnétiques comprenant au moins deux connecteurs.

La figure 11 illustre un ensemble de trois groupes de connecteurs 5A, 5B, et 5C. Le premier groupe de connecteurs 5A comprend deux connecteurs magnétiques 5 et une pièce de liaison 4A qui relie mécaniquement ces deux connecteurs magnétiques 5 l'un à autre, pour le maintien mécanique, et pour assurer entre eux une distance D1 de sécurité électrique. Les connecteurs magnétiques 5 sont fixés à la pièce de liaison 4A par pincement des capsules 56 des connecteurs magnétiques 5 dans deux pinces de la pièce de liaison 4A.

Le deuxième groupe de connecteurs 5B comprend deux connecteurs magnétiques 5 et une pièce de liaison 4B qui relie mécaniquement ces deux connecteurs magnétiques 5 l'un à autre, en maintenant une distance D2 de sécurité électrique, supérieure à la distance D1, pour le cas où l'écartement nécessaire entre les connecteurs 5 pour correspondre avec l'écartement des pièces conductrices 28 est plus important.

Le troisième groupe de connecteurs 5C comprend quatre connecteurs magnétiques 5 et une pièce de liaison 4C qui comporte quatre pinces recevant chacune l'une des quatre connecteurs magnétiques 5 en maintenant un écart entre ces quatre connecteurs magnétiques.

Les pièces de liaison 4A, 4B, 4C dans la figure 11 sont illustrées à titre d'exemple, d'autres formes de liaison entre les connecteurs magnétiques 5 pouvant être prévues.

## Revendications

1. Connecteur magnétique (5) pour la connexion d'un appareil électrique sur un tableau électrique (22), comprenant au moins un aimant (50 ; 7, 9), une pièce métallique conductrice (52) solidaire de cet aimant (50 ; 7, 9) et un câble de connexion (54) fixé sur la pièce métallique conductrice (52), **caractérisé en ce que** le connecteur magnétique (5) comprend en outre une capsule (56) en matière plastique surmoulée sur le câble de connexion (54), la pièce métallique conductrice (52) et l'aimant (50 ; 7, 9), excepté une surface de contact (500 ; 70, 90) de l'aimant (50 ; 7, 9) destinée à être mise en contact avec une pièce métallique (28) du tableau électrique (22), **en ce que** la capsule en matière plastique (56) présente une partie longitudinale (560) s'étendant selon un axe central (X5) et terminée par une surface plane (562) parallèle à la surface de contact (500 ; 70, 90) dudit au moins un aimant (50 ; 7, 9), et **en ce que** le câble (54) est orienté transversalement par rapport à la partie longitudinale (560) et encapsulé dans une partie radiale (564) de la capsule (56) qui prolonge la surface plane (562).

2. Connecteur magnétique selon la revendication 1, **caractérisé en ce qu'**il comporte un unique aimant (50) de forme cylindrique et présentant une rainure circonférentielle (50A) dans laquelle la matière de la capsule en matière plastique (56) est engagée.

3. Connecteur magnétique selon la revendication 1, **caractérisé en ce qu'**il comporte deux aimants (7, 9) de polarités inversées.

4. Connecteur magnétique selon la revendication 3, **caractérisé en ce que** les deux aimants (7, 9) sont de forme demi-cylindrique et séparés l'un de l'autre par une paroi (566) venue de matière avec la capsule (56).

5. Connecteur magnétique selon l'une des revendications précédentes, **caractérisé en ce que** la partie longitudinale (560) comprend au moins une nervure périphérique de préhension (560A) prévue dans le prolongement de la partie radiale (564) de la capsule (56).

6. Connecteur magnétique selon l'une des revendications précédentes, **caractérisé en ce que** la partie longitudinale (560) est de forme cylindrique et présente au moins un renflement longitudinal (560B), le renflement longitudinal étant configuré pour produire un frottement dans un logement (34) du tableau électrique (22) dans lequel le connecteur (5) est monté.

7. Connecteur magnétique selon la revendication 6, **caractérisé en ce que** la partie longitudinale (560) a un profil transversal elliptique, dont la plus grande dimension (L1) a une longueur, par rapport à la plus petite dimension (L2), supérieure de 0.2 à 0.4 mm.

8. Connecteur magnétique selon l'une des revendications précédentes, **caractérisé en ce que** la dimension longitudinale (L5) du connecteur (5), prise entre la surface de contact (500) de l'aimant (50) et la surface plane (562) de la capsule (56), est comprise entre 7 et 12 mm.

9. Groupe (5A, 5B, 5C) de connecteurs magnétiques, **caractérisé en ce qu'**il comprend au moins deux connecteurs magnétiques (5) selon l'une des revendications précédentes, chacun de ces connecteurs magnétiques (5) étant destiné à être connecté sur une pièce métallique (28) du tableau électrique (22), et une pièce de liaison (4A, 4B, 4C) sur laquelle chacun de ces connecteurs magnétiques (5) est fixé avec un écartement prédéfini (D1, D2).

## Patentansprüche

1. Magnetischer Verbinder (5) zum Verbinden eines elektrischen Geräts mit einer elektrische Schalttafel (22), umfassend mindestens einen Magneten (50; 7, 9), ein leitendes Metallteil (52), das fest mit diesem Magneten (50; 7, 9) verbunden ist, und ein Verbindungskabel (54), das an dem leitenden Metallstück (52) befestigt ist, **dadurch gekennzeichnet, dass** der magnetische Verbinder (5) ferner eine Kapsel (56) aus Kunststoff umfasst, die auf das Verbindungskabel (54), das leitende Metallstück (52) und den Magneten (50; 7, 9) aufgeformt ist, mit Ausnahme einer Kontaktfläche (500; 70, 90) des Magneten (50; 7, 9), die dazu bestimmt ist, mit einem Metallteil (28) der elektrischen Schalttafel (22) in Kontakt gebracht zu werden, dass die Kunststoffmaterialkapsel (56) einen Längsabschnitt (560) aufweist, der sich entlang einer Mittelachse (X5) erstreckt und durch eine ebene Fläche (562) parallel zu der Kontaktfläche (500; 70, 90) des mindestens einen Magneten (50; 7, 9) abgeschlossen ist, und dass das Kabel (54) quer zu dem Längsabschnitt (560) ausgerichtet und in einem radialen Abschnitt (564) der Kapsel (56) eingekapselt ist, der die ebene Fläche (562) verlängert.

2. Magnetischer Verbinder nach Anspruch 1, **dadurch gekennzeichnet, dass** er einen einzelnen Magneten (50) zylindrischer Form umfasst und eine umlaufende Nut (50A) aufweist, in die das Material der Kunststoffmaterialkapsel (56) eingreift.

3. Magnetischer Verbinder nach Anspruch 1, **dadurch gekennzeichnet, dass** er zwei Magnete (7, 9) mit umgekehrter Polarität umfasst.

4. Magnetischer Verbinder nach Anspruch 3, **dadurch gekennzeichnet, dass** die zwei Magnete (7, 9) von halbzylindrischer Form sind und durch eine Wand (566) voneinander getrennt sind, die aus einem Stück mit der Kapsel (56) besteht.

5. Magnetischer Verbinder nach einem der vorherigen Ansprüche, **dadurch gekennzeichnet, dass** der Längsabschnitt (560) mindestens eine periphere Greifrippe (560A) umfasst, die in der Verlängerung des radialen Abschnitts (564) der Kapsel (56) bereitgestellt ist.

6. Magnetischer Verbinder nach einem der vorherigen Ansprüche, **dadurch gekennzeichnet, dass** der Längsabschnitt (560) von zylindrischer Form ist und mindestens eine Längswölbung (560B) aufweist, wobei die Längswölbung konfiguriert ist, um in einer Aufnahme (34) der elektrischen Schalttafel (22), in der der Verbinder (5) montiert ist, Reibung zu erzeugen.

7. Magnetischer Verbinder nach Anspruch 6, **dadurch gekennzeichnet, dass** der Längsabschnitt (560) ein elliptisches Querprofil aufweist, dessen größte Abmessung (L1) verglichen mit der kleinsten Abmessung (L2) eine Länge aufweist, die 0,2 bis 0,4 mm größer ist.

8. Magnetischer Verbinder nach einem der vorhergehenden Ansprüche, **dadurch gekennzeichnet, dass** die Längsabmessung (L5) des Verbinders (5), genommen zwischen der Kontaktfläche (500) des Magneten (50) und der ebenen Fläche (562) der Kapsel (56), zwischen 7 und 12 mm ist.

9. Gruppe (5A, 5B, 5C) von magnetischen Verbindern, **dadurch gekennzeichnet, dass** sie mindestens zwei magnetische Verbinder (5) nach einem der vorherigen Ansprüche umfasst, wobei jeder dieser magnetischen Verbinder (5) dazu bestimmt ist, mit einem Metallteil (28) der elektrischen Schalttafel (22) verbunden zu werden, und ein Verbindungsteil (4A, 4B, 4C), an dem jeder dieser magnetischen Verbinder (5) mit einem vorbestimmten Abstand (D1, D2) befestigt ist.

## Claims

1. A magnetic connector (5) for connecting an electrical apparatus to an electrical panel (22), comprising at least one magnet (50; 7, 9), a conductive metal part (52) secured to this magnet (50; 7, 9), and a connecting cable (54) attached to the conductive metal part (52), **characterized in that** the magnetic connector (5) further comprises a cap (56) made of plastic material overmolded on the connecting cable (54), the conductive metal part (52) and the magnet (50; 7, 9), except for a contact surface (500; 70, 90) of the magnet (50; 7, 9) that is intended to make contact with a metal part (28) of the electrical panel (22), **in that** the cap made of plastic material (56) has a longitudinal part (560) extending along a central axis (X5) and terminated by a flat surface (562) parallel to the contact surface (500; 70, 90) of said at least one magnet (50; 7, 9), and **in that** the cable (54) is oriented transversely with respect to the longitudinal part (560) and encapsulated in a radial part (564) of the cap (56) that extends the flat surface (562).

2. The magnetic connector according to claim 1, **characterized in that** it comprises a single magnet (50) of cylindrical form and which has a circumferential groove (50A) in which the material of the cap made of plastic material (56) is engaged.

3. The magnetic connector according to claim 1, **characterized in that** it comprises two magnets (7, 9) of reverse polarities.

4. The magnetic connector according to claim 3, **characterized in that** the two magnets (7, 9) are of semicylindrical form and are separated from one another by a wall (566) made of a single piece with the cap (56).

5. The magnetic connector according to one of the preceding claims, **characterized in that** the longitudinal part (560) comprises at least one peripheral gripping ridge (560A) provided in the extension of the radial part (564) of the cap (56).

6. The magnetic connector according to one of the preceding claims, **characterized in that** the longitudinal part (560) is of cylindrical form and has at least one longitudinal bulge (560B), the longitudinal bulge being configured to produce friction in a housing (34) of the electrical panel (22) when the connector (5) is mounted.

7. The magnetic connector according to claim 6, **characterized in that** the longitudinal part (560) has an elliptical transverse profile, the greatest dimension of which has a length (L1), with respect to the smallest dimension (L2), that is greater by 0.2 to 0.4 mm.

8. The magnetic connector according to one of the preceding claims, **characterized in that** the longitudinal dimension (L5) of the connector (5), taken between the contact surface (500) of the magnet (50) and the flat surface (562) of the cap (56), is between 7 and 12 mm.

9. A set (5A, 5B, 5C) of magnetic connectors, **characterized in that** it comprises at least two magnetic connectors (5) according to one of the preceding claims, each of these magnetic connectors (5) being intended to be connected to a metal part (28) of the electrical panel (22), and a link part (4A, 4B, 4C) to which each of these magnetic connectors (5) is attached with a predefined separation (D1, D2).
